(19) Europäisches Patentamt / European Patent Office / Office européen des brevets

(11) **EP 3 336 910 A1**

(12) **DEMANDE DE BREVET EUROPEEN**

(43) Date de publication:
**20.06.2018 Bulletin 2018/25**

(51) Int Cl.:
***H01L 35/32*** *(2006.01)*     ***H01L 35/22*** *(2006.01)*

(21) Numéro de dépôt: **17207378.5**

(22) Date de dépôt: **14.12.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD TN**

(30) Priorité: **16.12.2016 FR 1662619**

(71) Demandeur: **Commissariat à l'Energie Atomique et aux Energies Alternatives**
**75015 Paris (FR)**

(72) Inventeur: **AIXALA, Luc**
**38120 SAINT-EGREVE (FR)**

(74) Mandataire: **Nony**
**11 rue Saint-Georges**
**75009 Paris (FR)**

(54) **GENERATEUR THERMOELECTRIQUE**

(57) Pièce présentant une forme de secteur annulaire et comportant, pour au moins 95,0% de la masse de la pièce, un bloc fritté présentant une forme de secteur annulaire et contenant un siliciure thermoélectrique dopé n ou dopé p.

Fig. 7

EP 3 336 910 A1

**Description**

La présente invention concerne un générateur thermoélectrique configuré pour générer un courant électrique par effet Seebeck, une pièce en un matériau thermoélectrique utile pour un tel générateur thermoélectrique, ainsi qu'un procédé de production de ladite pièce.

La récupération de chaleur par effet thermoélectrique au moyen d'un générateur thermoélectrique est bien connue et est mise en oeuvre dans de nombreuses applications. Un générateur thermoélectrique comporte généralement un matériau thermoélectrique dont il met à profit une propriété thermoélectrique, dénommée effet Seebeck : ainsi, lorsque deux zones différentes d'un matériau thermoélectrique sont portées à des températures respectivement différentes, une tension électrique à vide est générée entre les deux zones.

Par exemple, on connaît des pots d'échappement de véhicule automobile comportant un générateur thermoélectrique mettant à profit l'effet Seebeck, pour convertir une partie de l'énergie thermique des gaz d'échappement en énergie électrique.

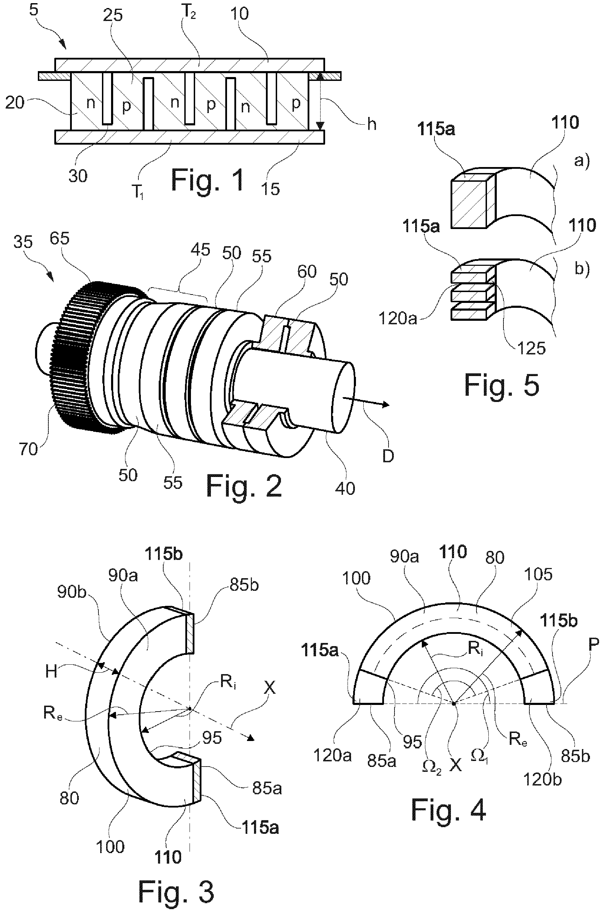

Un exemple de générateur thermoélectrique 5 de l'art antérieur, dit générateur thermoélectrique « plan », est décrit sur la figure 1. Il comporte une plaque supérieure 10, dédiée à former une source chaude de température $T_2$, et une plaque inférieure 15, dédiée à former une source froide de température $T_1$, les plaques prenant en sandwich une série de blocs 20, 25, chacun étant en un matériau thermoélectrique dopé n ou p. Les blocs sont disposés selon une direction parallèle aux plaques, la série étant constituée par la répétition d'un motif élémentaire formé d'un bloc en matériau thermoélectrique dopé n 20 et d'un bloc en matériau thermoélectrique dopé p 25. Deux blocs consécutifs sont reliés au moyen d'un connecteur 30 assurant une connexion électrique en série des blocs. En fonctionnement, un gradient de température $\Delta T = (T_2 - T_1)/h$ est établi dans chaque bloc. Dans le générateur plan, les blocs sont ainsi disposés thermiquement en parallèle.

On connait aussi des générateurs thermoélectriques généralement dénommés «tubulaires». Un exemple de générateur thermoélectrique tubulaire 35 de l'art antérieur est illustré sur la figure 2. Il comporte un échangeur de chaleur intérieur 40 sous forme d'un tube creux s'étendant selon une direction longitudinale D. Une pluralité d'anneaux cylindriques de révolution, formée par la répétition périodique d'un motif élémentaire 45 est disposée autour de l'échangeur de chaleur intérieur, le long de la direction longitudinale. Le motif élémentaire est constitué d'un anneau 50 cylindrique de révolution en matériau thermoélectrique dopé p et d'un anneau 55 cylindrique de révolution en matériau thermoélectrique dopé n, lesdits anneaux étant reliés électriquement au moyen d'un connecteur électrique 60 annulaire. Enfin, le générateur thermoélectrique de l'art antérieur comporte un échangeur de chaleur extérieur 65 comportant une portion creuse s'étendant selon la direction longitudinale, dans laquelle sont logés les anneaux. Les anneaux sont au contact par l'intermédiaire de leurs faces radialement extérieures respectives avec l'échangeur de chaleur extérieur. L'échangeur de chaleur comporte en outre des ailettes 70 s'étendant radialement vers l'extérieur pour optimiser l'échange de chaleur avec la source froide.

En fonctionnement, un fluide caloporteur, par exemple de l'eau, et froid circule à l'intérieur de l'échangeur de chaleur intérieur, formant une source froide et un fluide chaud circule autour de l'échangeur de chaleur extérieur, formant une source chaude. Un gradient de température radial est ainsi établi dans chaque anneau, résultant dans le développement d'une tension électrique par effet Seebeck.

Un générateur thermoélectrique tubulaire est généralement préféré à un générateur thermoélectrique plan dès lors qu'en fonctionnement, l'échange thermique au niveau de la source chaude s'effectue par convection avec un gaz, par exemple de l'air ou un gaz d'échappement d'un moteur à explosion.

Les anneaux d'un générateur thermoélectrique tubulaire sont généralement produits par métallurgie des poudres, en frittant une poudre comportant des particules en un matériau thermoélectrique.

Des matériaux thermoélectriques connus pour produire de tels anneaux sont le tellure de plomb PbTe et le tellure de bismuth $Bi_2Te_3$. Bien que présentant des propriétés thermoélectriques adaptées aux applications précitées, le tellure de plomb et le telluride de bismuth sont cependant toxiques et nocifs pour l'environnement. Il est donc souhaitable de s'en affranchir.

Les siliciures thermoélectriques, tels que MgSi, MgSiSn, MnSi ou encore SiGe présentent des propriétés thermoélectriques adaptées, notamment une figure de mérite maximale comprise entre 0,5 et 1,0 et présentent l'avantage d'une faible toxicité et nocivité. Cependant, pour former un produit par frittage d'une poudre en un tel matériau thermoélectrique, il est nécessaire d'appliquer une pression, supérieure à la pression atmosphérique, au cours du frittage. Un produit sous forme d'une galette pleine ou d'un bloc plein peut aisément être obtenu par un tel procédé. Ce n'est toutefois pas le cas dès lors que le produit présente la forme d'un anneau cylindrique de révolution tel qu'illustré sur la figure 2. La fabrication d'un tel anneau nécessite un moule présentant des portions définissant les faces radialement intérieure et radialement extérieure de l'anneau. Au cours du procédé de frittage, pour éviter la fissuration de l'anneau, la pression de frittage doit être régulée pour accommoder les déformations du moule par dilatation thermique et éviter l'adhésion des portions du moule à l'anneau, notamment sur la face radialement intérieure de l'anneau. En pratique, dans de nombreux cas, l'anneau fritté est fissuré voire rompu. En conséquence, le rendement d'un procédé de frittage sous pression d'un anneau en un matériau thermoélectrique à base de siliciure s'avère trop faible pour que le procédé puisse être mis en oeuvre à une échelle industrielle.

En variante, la fabrication d'un anneau peut être réalisée à partir de l'usinage d'une galette pleine obtenue par frittage sous pression. Cependant, outre la perte de matière résultant de l'usinage, un tel procédé introduit une étape supplémentaire au procédé de frittage décrit ci-dessus, ce qui s'avère rédhibitoire pour une mise en oeuvre à l'échelle industrielle.

En conséquence, il existe un besoin pour un générateur thermoélectrique, en particulier de forme générale tubulaire, comportant un matériau thermoélectrique peu toxique et peu nocif pour l'environnement, et présentant des propriétés thermoélectriques adaptées aux applications d'un générateur thermoélectrique tubulaire tel que décrit précédemment. Il existe aussi un besoin pour une pièce en ledit matériau thermoélectrique, adaptée à être assemblée au sein d'un tel générateur thermoélectrique.

L'invention vise à répondre à ce besoin, et concerne une pièce présentant une forme de secteur annulaire et comportant, pour au moins 95,0% de la masse de la pièce, un bloc fritté présentant une forme de secteur annulaire et contenant un siliciure thermoélectrique dopé n ou dopé p.

Comme cela apparaîtra dans la description détaillée qui va suivre, une pièce selon l'invention est aisée à produire, notamment en des quantités industrielles. Elle est par ailleurs parfaitement adaptée à la conversion thermoélectrique au sein d'un générateur thermoélectrique, notamment tel que selon l'invention et qui est décrit ci-après.

Un « secteur annulaire », par exemple illustré sur la figure 3, est une partie d'un anneau s'étendant autour d'un axe d'extension entre deux positions angulaires d'extrémités différentes l'une de l'autre, et le long d'une courbe moyenne sensiblement convexe. Le secteur annulaire n'est pas intégralement retourné sur lui-même et ne constitue donc pas un anneau. En particulier, l'axe d'extension peut être défini par l'intersection du plan orthogonal à une extrémité de la courbe moyenne avec le plan orthogonal à l'extrémité opposée de la courbe moyenne.

Par ailleurs, les faces radialement intérieure et radialement extérieure du secteur annulaire, c'est-à-dire situées respectivement à l'intérieur et à l'extérieur du secteur annulaire, le long d'un rayon généré à partir de l'axe d'extension peuvent présenter des formes différentes. De manière non limitative, la face radialement intérieure, respectivement la face radialement extérieure du secteur annulaire, est par exemple courbe ou multifacette.

La « courbe moyenne » passe par l'ensemble des barycentres des sections longitudinales de la pièce, les sections longitudinales étant parallèles à l'axe d'extension. La courbe moyenne peut être de forme variée, à l'exception d'un unique segment de droite. En particulier, elle peut être définie par un polygone ou un arc d'ellipse, un arc parabolique, un arc hyperbolique ou de préférence, un arc circulaire. Elle peut notamment présenter des lobes, définissant une portion concave de la courbe moyenne. Par exemple, la courbe moyenne est une partie d'un contour réniforme. Toutefois, la courbe moyenne étant sensiblement convexe, la portion concave est de longueur au moins 5, voire 10 fois inférieure à la longueur de la courbe moyenne entre les positions angulaires initiale et finale.

Suivant des modes de réalisation préférés, une pièce selon l'invention comprend une ou plusieurs des caractéristiques suivantes, prises seules ou en combinaison.

De préférence, le siliciure thermoélectrique est choisi parmi MgSi, MgSiSn, MnSi, SiGe, $Mg_2Si$, $Mg_2SiSn$ et leurs mélanges. Un tel siliciure présente des propriétés thermoélectriques optimales pour la conversion thermoélectrique par effet Seebeck, sans être toxique ni nocif pour l'environnement.

Le siliciure thermoélectrique peut être dopé n ou dopé p. De préférence, le siliciure thermoélectrique dopé n comporte plus de 0,05% et, de préférence moins de 1,0% d'antimoine Sb et/ou de phosphore P, sur la base de la masse du siliciure thermoélectrique. De préférence, le siliciure thermoélectrique dopé p comporte plus de 0,05% et de préférence moins de 1% de bore B de, sur la base de la masse du siliciure thermoélectrique.

En ce qui concerne le bloc, de préférence il comporte de préférence plus de 99,0% de siliciure thermoélectrique dopé n ou p, en pourcentages en masse sur la base de la masse du bloc, de manière à maximiser les propriétés thermoélectriques du bloc. Le complément à 100% de la masse du bloc peut être constitué par des impuretés, par exemple de l'aluminium Al.

Par ailleurs, dans un mode de réalisation qui sera illustré par la suite, la pièce consiste en le bloc.

Pour ce qui concerne la forme du bloc, au moins une, de préférence toutes les sections longitudinales du bloc présentent une forme circulaire ou une forme oblongue ou une forme ovale ou de préférence polygonale, notamment trapézoïdale ou de préférence rectangulaire, par exemple carrée, une section longitudinale du bloc étant obtenue par coupe du bloc par un plan contenant l'axe d'extension. En particulier, deux sections longitudinales de positions angulaires différentes peuvent présenter des formes différentes ou de préférence identiques. De préférence, deux sections longitudinales de positions angulaires différentes sont identiques. Par exemple, le bloc présente une section longitudinale rectangulaire, voire carrée, identique quelle que soit la position angulaire autour de l'axe d'extension.

De manière plus particulièrement préférée, le bloc présente une forme de portion d'anneau cylindrique de révolution. En particulier, dans un mode de réalisation, le bloc peut présenter une forme de portion de demi-anneau cylindrique de révolution.

Par ailleurs, le bloc comporte de préférence deux faces transverses parallèles entre elles, et de préférence perpendiculaires à l'axe d'extension du bloc.

De préférence, le bloc s'étend autour de l'axe d'extension et le long d'au moins une partie de la courbe moyenne autour et le long desquels respectivement s'étend la pièce.

Enfin, le bloc comporte des faces latérales d'extrémités, de préférence définies chacune par un plan contenant l'axe d'extension.

Pour sa part, de préférence, la pièce présente une forme de portion d'anneau cylindrique de révolution. De manière particulièrement préférée, la pièce présente une forme de moitié de demi-anneau cylindrique de révolution.

Par ailleurs, la pièce comporte de préférence deux faces transverses parallèles entre elles, et de préférence perpendiculaires à l'axe d'extension de la pièce.

De préférence, la pièce comporte des faces latérales d'extrémités définies chacune par un plan contenant l'axe d'extension.

Dans un mode de réalisation, les étendues angulaires du bloc et de la pièce sont égales. L' «étendue angulaire» d'un élément, par exemple un bloc ou une pièce, est définie par l'angle parcouru autour de l'axe d'extension de l'élément pour joindre les deux extrémités opposées de la courbe moyenne de l'élément.

De préférence, l'étendue angulaire du bloc est supérieure à 45°, de préférence supérieure à 90°, voire de préférence supérieure à 175° et/ou inférieure à 180°, notamment comprise entre 178,5° et 179,5°, notamment égale à 179°. Une pièce comportant un bloc présentant une telle étendue angulaire est d'assemblage aisé pour fabriquer le générateur thermoélectrique selon l'invention.

De préférence, le bloc présente un rayon intérieur supérieur ou égal à 2 mm, de préférence supérieur ou égal à 4 mm, voire de préférence supérieur ou égal à 5 mm et/ou inférieur ou égal à 10 mm, de préférence inférieur ou égal à 8 mm, de préférence inférieur ou égal à 7 mm, notamment égal à 6 mm et/ou un rayon extérieur supérieur ou égal à 5 mm, de préférence supérieur ou égal à 7 mm, voire de préférence supérieur ou égal à 8 mm et/ou inférieur ou égal à 13 mm, de préférence inférieur ou égal à 11 mm, voire de préférence inférieur ou égal à 10 mm, notamment égal à 9 mm et/ou une hauteur supérieure ou égale à 1 mm, de préférence supérieure ou égale à 1,5 mm et/ou inférieure ou égale à 3 mm, de préférence inférieure ou égale à 2,5 mm.

En particulier, le rapport du rayon extérieur sur le rayon intérieur peut être compris entre 1,05 et 1,2.

Par ailleurs, dans un mode de réalisation, une face latérale d'extrémité du bloc est recouverte d'au moins un revêtement isolant en un matériau électriquement et de préférence thermiquement isolant, de préférence étant de l'alumine. En particulier, la face latérale d'extrémité opposée peut être recouverte d'un revêtement isolant formé du même matériau. De cette façon, comme cela apparaîtra dans la suite de la description, le revêtement isolant isole électriquement et le cas échéant thermiquement la pièce selon l'invention d'une autre pièce avec laquelle elle est au contact au sein du générateur thermoélectrique.

Le revêtement isolant peut être fritté ou obtenu par une méthode choisie parmi l'aspersion ou la pulvérisation plasma.

De préférence, l'épaisseur du revêtement isolant est inférieure à 200 $\mu$m, de préférence comprise entre 70 $\mu$m et 120 $\mu$m, par exemple égale à 100 $\mu$m. De préférence, les épaisseurs respectives des revêtements isolants disposées sur chacune face latérales d'extrémité du bloc sont égales.

Le revêtement isolant peut s'étendre sur au moins une portion, voire sur l'ensemble de la face latérale d'extrémité. Dans une variante, il peut comporter au moins une, de préférence plusieurs rainures, de préférence s'étendant selon une direction parallèle à l'axe d'extension. La au moins une rainure peut déboucher sur la face latérale d'extrémité.

Par ailleurs, l'invention concerne un procédé de production d'une pièce selon l'invention, le procédé comportant les étapes successives suivantes consistant à :

a) disposer d'un mélange de matières premières pour former une charge de départ,
b) mettre en forme une préforme à partir de la charge de départ,
c) optionnellement, recouvrir partiellement, voire intégralement, au moins une face de la préforme d'un enduit, de sorte à obtenir une préforme recouverte,
d) fritter la préforme, optionnellement recouverte, avec application d'une pression de sorte à obtenir une préforme frittée,
e) optionnellement, revêtir au moins partiellement, voire intégralement, au moins une face de la préforme frittée d'un revêtement isolant comportant un matériau électriquement isolant et de préférence thermiquement isolant, de sorte à obtenir une préforme frittée revêtue,

la préforme frittée, optionnellement revêtue à l'étape e), consistant en ladite pièce.

L'invention vise encore un générateur thermoélectrique s'étendant selon une direction longitudinale et comportant au moins une première pièce et au moins une deuxième pièce,

chacune des première et deuxième pièces étant selon l'invention, ou obtenue ou susceptible d'être obtenue par le procédé selon l'invention,

le siliciure thermoélectrique de la première pièce, respectivement de la deuxième pièce, étant dopé n, respectivement dopé p,

les première et deuxième pièces étant disposées autour de la direction longitudinale de sorte qu'au moins un plan de coupe du générateur thermoélectrique, normal à la direction longitudinale, coupe la première pièce et la deuxième pièce.

Avantageusement, la disposition de la première pièce par rapport à la deuxième pièce au sein du générateur thermoélectrique, induite par la forme spécifique en secteur annulaire de chacune des première et deuxième pièces, résulte en un générateur thermoélectrique de fabrication simplifiée, pouvant être produit industriellement en masse et, comme cela apparaîtra plus clairement par la suite, pouvant présenter un rendement de conversion thermoélectrique par effet Seebeck sensiblement égal à celui d'un générateur thermoélectrique de l'art antérieur comportant un volume identique du même siliciure thermoélectrique.

Suivant des modes de réalisation préférés, un générateur thermoélectrique selon l'invention comprend une ou plusieurs des caractéristiques suivantes, prises seules ou en combinaison.

La direction longitudinale est courbe ou, de préférence, est une droite.

Les axes d'extension des première et deuxième pièces sont de préférence parallèles à la direction longitudinale. De préférence l'axe d'extension de la première pièce et/ou l'axe d'extension de la deuxième pièce sont confondus avec la direction longitudinale.

De préférence, les étendues angulaires des blocs respectifs des première et deuxième pièces sont égales, et de préférence comprises entre 178,5° et 179,5°. Ainsi, notamment lorsque les faces latérales d'extrémités sont recouvertes chacune du revêtement isolant, les pièces peuvent être aisément assemblées au sein du générateur thermoélectrique.

En ce qui concerne la forme des pièces, dans un mode de réalisation, les étendues angulaires respectives des première et deuxième pièces peuvent être égales, et de préférence égales à 180°C.

De préférence, la première pièce présente une forme de portion d'anneau cylindrique de révolution et la deuxième pièce présente une forme de portion d'anneau cylindrique de révolution. De préférence, la hauteur, le rayon intérieur et le rayon extérieur de la première pièce sont égaux respectivement à la hauteur, au rayon intérieur et au rayon extérieur de la deuxième pièce.

Par ailleurs, lorsqu'observée selon la direction longitudinale, la première pièce est de préférence symétrique de la deuxième pièce par rapport à un plan contenant ladite direction longitudinale. Au sens de la présente invention, deux pièces symétriques lorsqu'observées selon la direction longitudinale peuvent être décalées l'une par rapport à l'autre selon la direction longitudinale.

De préférence, les faces d'extrémité de la première pièce sont en regard, voire au contact des faces latérales d'extrémités respectives de la deuxième pièce.

De préférence, les première et deuxième pièces sont décalées l'une par rapport à l'autre selon la direction longitudinale. Le décalage entre les première et deuxième pièces simplifie la fabrication du générateur thermoélectrique, en particulier lorsque le générateur thermoélectrique comporte des pluralités de première pièces et de deuxième pièces. La connexion électrique entre deux pièces consécutives est ainsi facilitée. De préférence, ledit décalage selon la direction longitudinale est compris entre 0,3 et 0,6 fois, de préférence entre 0,45 fois et 0,55 fois, de préférence 0,5 fois la hauteur de la première pièce. En variante, ledit décalage selon la direction longitudinale est de préférence compris entre 0,3 et 0,6 fois, de préférence entre 0,45 fois et 0,55 fois, de préférence 0,5 fois la hauteur de la deuxième pièce.

Par ailleurs, les faces radialement intérieures des première et deuxième pièces sont en regard.

Outre les première et deuxième pièces, le générateur thermoélectrique peut comporter un échangeur de chaleur intérieur présentant la forme d'un tube creux, de préférence cylindrique de révolution, dont l'axe est parallèle ou de préférence confondu avec la direction longitudinale. De préférence, la face radialement intérieure de la première pièce et/ou la face radialement intérieure de la deuxième pièce est au contact de la face radialement extérieure de l'échangeur de chaleur intérieur et est de forme complémentaire à la face radialement extérieure de l'échangeur de chaleur intérieur. De préférence, l'échangeur de chaleur intérieur et la première pièce sont de formes complémentaires et/ou l'échangeur de chaleur intérieur et la deuxième pièce sont de formes complémentaires.

Le générateur thermoélectrique peut comporter un échangeur de chaleur extérieur, présentant une forme générale cylindrique, d'axe de préférence confondu avec la direction longitudinale du générateur thermoélectrique, et creuse. De préférence, la face radialement intérieure de l'échangeur de chaleur extérieur est au contact de la face radialement extérieure de la première pièce et/ou de la deuxième pièce.

Par ailleurs, dans un mode de réalisation, le générateur peut comporter en outre au moins un organe isolant formé d'un matériau électriquement isolant, par exemple de l'alumine $Al_2O_3$, et de préférence thermiquement isolant, par exemple du quartz et/ou un verre, l'organe isolant étant disposé entre les première et deuxième pièces.

De préférence, l'ensemble formé par les première et deuxième pièces, et le cas échéant par le au moins un organe isolant, encercle intégralement la direction longitudinale. De cette façon, lorsque le générateur thermoélectrique est en fonctionnement, ledit ensemble est soumis à un flux thermique selon toutes les directions radiales autour de et orthogonales à l'axe longitudinal, ce qui améliore le rendement de conversion thermoélectrique.

Par ailleurs, afin de générer une tension de sortie élevée, de préférence le générateur électrique comporte en outre un connecteur électrique reliant électriquement en série les première et deuxième pièces. Le connecteur électrique peut notamment s'étendre le long des faces radialement extérieures des première et des deuxièmes pièces et de préférence dans un plan orthogonal à la direction longitudinale, et est de préférence fixé sur lesdites pièces au moyen d'une brasure en alliage AlSi. En variante, le connecteur électrique peut s'étendre le long des faces radialement intérieures des première et des deuxièmes pièces et de préférence dans un plan orthogonal à la direction longitudinale, et est de préférence fixé sur lesdites pièces au moyen d'une brasure en alliage SnPb.

Par exemple, le connecteur électrique présente la forme d'un ruban, dont la largeur, mesurée selon la direction longitudinale du générateur thermoélectrique est de préférence comprise entre 1 mm et 5 mm, et la longueur, mesurée le long des faces radialement extérieures des premières et des deuxièmes pièces est de préférence comprise entre 5 mm et 20 mm.

De préférence, le connecteur électrique est constitué en tout ou partie par un métal choisi parmi le cuivre, le nickel, le molybdène et leurs mélanges.

Par ailleurs, afin d'augmenter la tension et la puissance électrique générées par le générateur thermoélectrique, de préférence le générateur comporte une pluralité de premières pièces et une pluralité de deuxièmes pièces, la pluralité de premières pièces, respectivement la pluralité de deuxièmes pièces étant au moins partiellement, voire intégralement, définie par répétition, de préférence périodique, selon la direction longitudinale, d'un motif élémentaire constitué par une première pièce, respectivement une deuxième pièce.

De préférence, l'ensemble formé de la pluralité de premières pièces et de la pluralité de deuxièmes pièces est au moins partiellement, voire intégralement, défini par répétition, de préférence périodique, selon la direction longitudinale, d'un motif élémentaire constitué par une première pièce et une deuxième pièce.

Ainsi, chaque pièce de la pluralité de premières pièces comporte un siliciure thermoélectrique dopé n et chaque pièce de la pluralité de deuxièmes pièces comporte un siliciure thermoélectrique dopé p.

Le siliciure thermoélectrique des pièces de la pluralité de premières pièces peut être différent ou identique au siliciure thermoélectrique des pièces de la pluralité de deuxièmes pièces.

De préférence la pluralité de premières pièces, respectivement la pluralité de deuxièmes pièces comporte au moins deux, de préférence au moins cinq, voire de préférence au moins dix pièces. En particulier, la pluralité de premières pièces et la pluralité de deuxièmes pièces peuvent comporter le même nombre de pièces.

De préférence, au moins 90% en nombre, voire au moins 95% en nombre, voire toutes les pièces de la pluralité de premières pièces, respectivement de la pluralité de deuxièmes pièces sont identiques.

En particulier, au moins 90% en nombre, voire au moins 95% en nombre, voire toutes les pièces du générateur thermoélectriques sont identiques.

De préférence, les pluralités de premières pièces et de deuxièmes pièces sont disposées de part et d'autre d'un plan, le plan comportant de préférence la direction longitudinale du générateur thermoélectrique. Ainsi, les pièces dopées n et dopées p sont alternés selon un trajet sensiblement hélicoïdal autour de la direction longitudinale.

Par ailleurs, deux pièces consécutives de la pluralité de premières pièces, respectivement de la pluralité de deuxièmes pièces peuvent être espacées selon la direction longitudinale d'une distance, séparant les faces transverses en regard desdites pièces, comprise entre 0,5 mm et 2 mm, voire comprise entre 1,0 mm et 1,5 mm, la distance étant mesurée selon la direction longitudinale du générateur thermoélectrique.

Par ailleurs, la pluralité de premières pièces et la pluralité de deuxièmes pièces définissent un ensemble dont l'enveloppe convexe est de forme générale tubulaire et creuse s'étendant selon la direction longitudinale. En particulier, les pièces desdites pluralités disposées à une extrémité longitudinale de l'ensemble formé par lesdites pluralités, dites pièces d'extrémité, peuvent présentent des faces transverses parallèles et disposées dans un même plan. En particulier, une pièce d'extrémité de la pluralité de premières pièces, respectivement de la pluralité de deuxièmes pièces, présente une hauteur inférieure, par exemple deux fois inférieure, à une pièce d'extrémité de la pluralité de deuxièmes pièces, respectivement de la pluralité de premières pièces, disposée à la même extrémité du générateur thermoélectrique.

En ce qui concerne la connexion électrique des dites pluralités de pièces, une pièce de la pluralité de premières pièces est de préférence reliée électriquement à une pièce de la pluralité de deuxièmes pièces au moyen d'un connecteur électrique disposé sur les faces radialement extérieures desdites pièces. En outre, la pièce de la pluralité de premières pièces est reliée électriquement à une autre pièce de la pluralité de deuxièmes pièces au moyen d'un autre connecteur électrique disposé sur les faces radialement intérieures desdites pièces, les pièces de la pluralité de deuxièmes pièces étant de préférence adjacentes selon la direction longitudinale.

De préférence, une face latérale d'extrémité d'une pièce de la pluralité de premières pièces est en regard d'une face latérale d'une pièce de la pluralité de deuxièmes de pièces et d'une face latérale d'extrémité d'une autre pièce de la pluralité de deuxièmes pièces, lesdites pièces de la pluralité de deuxièmes pièces étant de préférence adjacentes selon la direction longitudinale.

Enfin, dans un mode de réalisation, l'organe isolant est une plaque s'étendant le long de l'axe longitudinal du générateur électrique, et est pris en sandwich entre une des faces latérales d'extrémité de chaque pièce de la pluralité de premières pièces et une des faces latérales d'extrémité de la pluralité de deuxièmes pièces.

L'invention concerne enfin un dispositif choisi parmi un pot d'échappement d'un véhicule automobile, notamment comportant un moteur à essence, un appareil de recirculation de gaz brûlé d'un moteur à explosion, notamment à essence ou diesel, d'un véhicule automobile, le dispositif comportant un générateur thermoélectrique selon l'invention.

D'autres caractéristiques et avantages de l'invention apparaîtront encore à la lecture de la description détaillée qui va suivre et à la lecture du dessin annexé dans lequel :

- la figure 1 illustre schématiquement un générateur thermoélectrique plan de l'art antérieur,
- la figure 2 représente, selon une vue en perspective, un écorché d'un générateur tubulaire de l'art antérieur,
- la figure 3 illustre une variante d'une pièce selon l'invention vue en perspective,
- la figure 4 est une vue de la pièce illustrée sur la figure 3 selon l'axe longitudinal de ladite pièce,
- la figure 5 représente une vue des faces d'extrémités d'un bloc recouvert d'un revêtement de variantes de pièces selon l'invention, et
- les figures 6 à 9 illustrent différents exemples de réalisation du générateur thermoélectrique de l'invention vus en perspective.

Dans le dessin annexé, les proportions réelles des divers éléments constitutifs ou leurs espacements n'ont pas été toujours été respectés dans un souci de clarté. Par ailleurs, certains éléments peuvent ne pas avoir été représentés en contact les uns avec les autres dans un souci de clarté, alors qu'ils le sont en pratique.

Par ailleurs, des éléments identiques peuvent être numérotés au moyen de références différentes.

Les figures 1 et 2 ont été décrites précédemment. Les figures 3 et 4 illustrent un mode de réalisation préféré d'une pièce selon l'invention.

La pièce 80 illustrée sur la figure 3 présente une forme de demi anneau cylindrique de révolution d'axe X. Elle comporte deux faces latérales d'extrémité 85a-b, chacune d'entre elles étant définies par un plan P contenant l'axe d'extension X de la pièce, représenté en pointillés sur la figure 4. La pièce comporte par ailleurs deux faces transverses 90a-b opposées, parallèles entre elles, normales à l'axe X et séparées selon une direction parallèle à l'axe X par la hauteur H de la pièce. Enfin, elle présente une face radialement intérieure 95 et une face radialement extérieure 100 s'étendant respectivement le long d'un arc de cercle de rayon intérieur $R_i$ et d'un arc de cercle de rayon extérieur $R_e$ respectivement.

La courbe moyenne 105 est un arc de cercle de rayon égal à $(R_i + R_e)/2$ passant par le centre des sections longitudinales rectangulaires.

L'étendue angulaire $\Omega_1$ de la pièce illustrée sur la figure 3 est de 180°.

Par ailleurs, la pièce comporte un bloc 110 fritté contenant pour plus de 99,0% de sa masse un matériau thermoélectrique siliciure dopé n ou p, dont chacune des faces latérales d'extrémité est recouverte d'un revêtement isolant 115a-b.

Le bloc 110 présente une forme de portion d'anneau cylindrique de révolution d'axe X, les rayon intérieur, rayon extérieur et hauteur du bloc étant égaux respectivement aux rayon intérieur, rayon extérieur et hauteur de la pièce.

Dans la variante illustrée sur la figure 3, le bloc présente des faces latérales d'extrémité 120a-b, chacune étant intégralement recouverte par un revêtement isolant en alumine et d'épaisseur 100 $\mu$m. En variante, une des faces latérales d'extrémité peut être exempte de revêtement isolant.

Le bloc présente une étendue angulaire $\Omega_2$, inférieure à celle de la pièce et égale à 179°.

La pièce illustrée sur la figure 5a présente un revêtement recouvrant intégralement la face latérale d'extrémité du bloc.

La variante illustrée sur la figure 5b diffère de la pièce illustrée sur les figures 3 et 4 et 5a uniquement en ce que, sur chacune des faces latérales d'extrémité du bloc, le revêtement isolant comporte des rainures 125 s'étendant selon une direction parallèle à l'axe X. Dans le cas où la pièce est au contact par l'intermédiaire du revêtement isolant avec une autre pièce au sein d'un générateur thermoélectrique comme cela sera détaillé par la suite, les rainures améliorent l'isolation thermique entre les deux pièces en contact, en réduisant le transfert du flux thermique entre elles. Comme cela est illustré sur la figure 5b, de préférence les rainures s'étendent sur l'intégralité de l'épaisseur du revêtement isolant et débouchent sur la face latérale d'extrémité.

Dans une variante non illustrée la pièce peut consister en un bloc fritté tel que représenté sur les figures 3 et 4, et dont les deux faces d'extrémités sont exemptes de revêtement isolant. Ainsi, l'étendue angulaire d'une telle pièce est égale à celle du bloc, en l'espèce égale à 179°.

Pour produire une pièce selon l'invention, on peut mettre en oeuvre le procédé de production selon l'invention.

A l'étape a), on dispose d'un mélange de matières premières pour former une charge de départ.

L'homme du métier sait aisément choisir les matières premières de sorte que la préforme frittée, optionnellement revêtue, consiste en la pièce selon l'invention.

En particulier, à l'étape a), les matières premières peuvent comprendre une poudre comportant, voire consistant en des particules de siliciure thermoélectrique. La poudre présente de préférence une taille médiane, comprise entre 10 $\mu$m et 100 $\mu$m.

La mise en forme de la préforme peut être réalisée selon des méthodes classiques connues de l'homme du métier. De préférence, la préforme en fin d'étape c) présente une forme de portion de cylindre de révolution.

A l'étape c), optionnelle, de préférence, l'enduit comporte un matériau électriquement isolant et de préférence thermiquement isolant. En variante, il peut comporter un précurseur du matériau électriquement isolant et de préférence thermiquement isolant.

En particulier, l'enduit peut être une solution du matériau électriquement isolant, par exemple de l'alumine, dans un solvant, par exemple de l'éthanol. De préférence, le matériau électriquement isolant est tel que décrit précédemment.

De préférence, on recouvre de préférence au moins une, de préférence les deux faces latérales d'extrémités de la préforme avec l'enduit. L'enduit peut être appliqué sur la ou lesdites faces au moyen d'un pinceau, ou par pulvérisation. Préalablement au dépôt, un masque amovible, de préférence s'étendant selon une direction parallèle à l'axe de la préforme et sur toute la hauteur de la préforme, peut être disposé sur la face latérale d'extrémité de la préforme. Ainsi, suite à l'application de l'enduit et retrait du masque, la zone de la face latérale d'extrémité de la préforme sur laquelle est disposée le masque est exempte d'enduit.

A l'étape d), le frittage est opéré avec l'application d'une pression supérieure à la pression atmosphérique.

De préférence, la pression est comprise entre 10 MPa et 40 MPa. Le frittage est par ailleurs opéré à une température de frittage comprise entre 500°C et 700°C et/ou pendant une durée de maintien à la température de frittage comprise entre 10 min et 30 min.

En fin d'étape d), on obtient une préforme frittée définissant le bloc de la pièce selon l'invention. En particulier, lorsque l'étape c) est mise en oeuvre, au cours de l'étape d), l'enduit est fritté et forme le revêtement isolant de la pièce selon un mode de réalisation de l'invention.

L'étape e), optionnelle est préférentiellement mise en oeuvre en l'absence de mise en oeuvre de l'étape c). Le revêtement isolant à l'étape e) peut notamment être obtenu par dépôt du matériau électriquement isolant au moyen d'un plasma.

Comme cela a déjà été décrit plus haut, la pièce selon l'invention est particulièrement utile pour un générateur thermoélectrique, de préférence tel que selon l'invention.

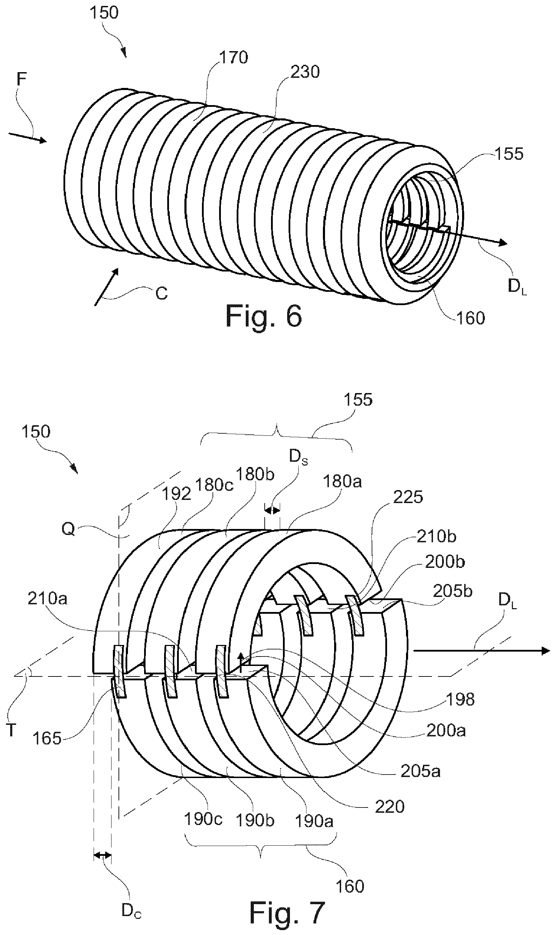

Le générateur thermoélectrique 150 selon l'invention, illustré sur la figure 6 s'étend selon une direction longitudinale droite $D_L$. Dans une variante non représentée, la direction longitudinale peut être courbe.

Le générateur thermoélectrique est de forme générale tubulaire. Il comporte un échangeur de chaleur intérieur, non représenté présentant une forme de tube creux cylindrique de révolution, une pluralité 155 de premières pièces, une pluralité 160 de deuxièmes pièces, une pluralité de connecteurs électriques 165, et un échangeur de chaleur extérieur 170 présentant une forme générale tubulaire creuse. Une couche d'alumine est par ailleurs disposée sur les faces extérieures et intérieures des première et deuxième pièces pour les isoler électriquement des échangeurs de chaleur extérieurs et intérieurs 170.

L'axe de l'échangeur de chaleur extérieur et l'axe de l'échangeur de chaleur extérieur sont confondus avec la direction longitudinale.

La pluralité 155 de premières pièces est constituée de pièces telles que décrites précédemment et illustrées sur les figures 3 et 4, chaque pièce de la pluralité de premières pièces comportant un bloc en un matériau siliciure dopé n.

La pluralité 160 de deuxièmes pièces est constituée de pièces identiques à celles constituant celles de la pluralité de premières pièces à ceci près que chacune des pièces de la pluralité de deuxièmes pièces comporte un bloc en un siliciure thermoélectrique dopé p.

Les axes d'extension de chaque pièce des pluralités de premières pièces et de deuxièmes pièces sont confondus avec la direction longitudinale.

Par ailleurs, la face radialement intérieure de chaque pièce des pluralités de premières pièces et de deuxième pièces est de forme complémentaire et au contact de la face radialement extérieure de l'échangeur de chaleur intérieur. La face radialement extérieure de chaque pièce des pluralités de premières et deuxièmes pièces est de forme complémentaire et au contact de la face radialement intérieure l'échangeur de chaleur intérieur. En fonctionnement, un liquide froid circule à l'intérieur de l'échangeur de chaleur intérieur, comme indiqué par la flèche F et un fluide chaud circule autour de la surface extérieure de l'échangeur thermique extérieur, l'écoulement du fluide chaud s'effectuant de préférence selon une direction normale à l'axe longitudinal, comme illustré au moyen de la flèche C. Ainsi, aussi bien dans les pièces de la pluralité de premières pièces que dans les pièces de la pluralité de deuxièmes pièces, un gradient thermique peut être établi radialement dans les blocs de siliciure thermoélectrique des pièces respectives.

Les pièces 180a-c de la pluralité 155 de premières pièces sont réparties régulièrement le long de la direction longitudinale, par répétition périodique d'un motif élémentaire constitué d'une pièce 180c. Les pièces 190a-c de la pluralité 160 de deuxièmes pièces sont réparties régulièrement le long de la direction longitudinale, par répétition périodique d'un motif élémentaire constitué d'une pièce 190c.

Par ailleurs, les pièces 180a-c de la pluralité de premières pièces sont séparées les unes des autres le long de la direction longitudinale et les pièces 190a-c de la pluralité de deuxièmes pièces sont séparées les unes des autres le long de la direction longitudinale.

Par ailleurs, l'ensemble formé de la pluralité 155 de premières pièces et de la pluralité 160 de deuxièmes pièces est défini par répétition, de préférence périodique, selon la direction longitudinale, d'un motif élémentaire 192 constitué par une première pièce 180c et une deuxième pièce 190c.

Notamment, deux pièces adjacentes sont espacées d'une distance Ds, mesurée selon une direction parallèle à la direction longitudinale, séparant les faces transverses en regard des deux pièces égale à 0,5 mm.

Par ailleurs, un plan Q normal à la direction longitudinale coupant une pièce 180a-c de la pluralité 155 de premières pièces coupe une pièce 190 de la pluralité 160 de deuxièmes pièces.

Les pièces 180a-c de la pluralité de premières pièces sont toutes disposées d'un côté d'un plan T contenant la direction longitudinale $D_L$ et les pièces 190a-c de la pluralité de deuxièmes pièces sont toutes disposées de l'autre côté dudit plan T. Par ailleurs, selon la disposition des pièces dans le générateur thermoélectrique de la figure 7, lorsqu'observée selon la direction longitudinale, une pièce de la pluralité de premières pièces est symétrique d'une pièce de la pluralité de deuxièmes pièces. Au sens de la présente invention, deux pièces symétriques lorsqu'observées selon la direction longitudinale peuvent être décalées l'une par rapport à l'autre selon la direction longitudinale.

Comme cela a été décrit précédemment, chacune des pièces du générateur présente une forme de demi-anneau cylindrique de révolution. Le générateur comporte m pièces 180a-c dopées n et m pièces 190a-c dopées p. Telles que disposées entre les échangeurs de chaleur intérieur et extérieur comme décrit précédemment, chacune des pièces est traversée, lors du fonctionnement de l'échangeur thermoélectrique, par un flux thermique Q. Le flux thermique total traversant la pluralité de premières pièces, respectivement la pluralité de deuxièmes pièces, est égal à m × Q. A titre comparatif, un générateur thermoélectrique de l'art antérieur, tel qu'illustré sur la figure 2 (qui diffère notamment du générateur thermoélectrique selon l'invention illustré sur la figure 6 en ce qu'il comporte des anneaux dopés n et dopés p alternés selon la direction longitudinale, de rayons interne et externe et hauteur identiques aux pièces du générateur thermoélectrique de la figure 6, et présente une longueur identique à celle du générateur thermoélectrique de la figure 6) contient $\dfrac{m}{2}$ anneaux dopés

n et $\dfrac{m}{2}$ anneaux dopés p. Dans des conditions de fonctionnement identiques, chaque anneau reçoit un flux thermique 2 × Q, si bien que le flux thermique total reçu par l'ensemble des anneaux dopés n, respectivement dopés p est égal à $\dfrac{m}{2} \times 2 \times Q = m \times Q.$

Le rendement de conversion thermoélectrique du générateur thermoélectrique selon l'invention est donc similaire à celui d'un générateur thermoélectrique doté d'anneaux de l'art antérieur, tel que décrit précédemment, tout en étant plus simple à fabriquer industriellement.

Par ailleurs, comme cela est observé sur la figure 7, la pluralité 160 de deuxièmes pièces est décalée par rapport à la pluralité 155 de premières pièces le long de la direction longitudinale. Une pièce 190a-c de la pluralité de deuxièmes pièces en regard, selon une direction orthoradiale (telle que par exemple référencée par le numéro 198 entre les pièces 180a et 190a), est décalée d'une distance De égale à la moitié de la hauteur des pièces H, par rapport à une pièce 180a-c de la pluralité de premières pièces, mesurée selon la direction longitudinale.

La figure 7 est un détail du générateur électrique de la figure 6, dans lequel l'échangeur de chaleur intérieur et l'échangeur de chaleur extérieur ont été omis, notamment de manière à illustrer l'avantage du décalage entre une pièce de la pluralité de premières pièces et une pièce de la pluralité de deuxièmes pièces en regard.

Chaque pièce de la pluralité de premières pièces est reliée électriquement en série avec deux pièces de la pluralité de deuxièmes pièces, lesdites deux pièces de la pluralité de deuxièmes pièces étant adjacentes.

Comme cela est illustré sur la figure 7, une pièce 180a de la pluralité de premières pièces présente des faces latérales d'extrémités 200a-b en regard et superposées aux faces latérales d'extrémités 205a-b d'une pièce 190a de la pluralité de deuxièmes pièces et aux faces latérales d'extrémités 210a-b d'une autre pièce 190b de la pluralité de deuxièmes pièces, adjacente à ladite pièce 190a de la pluralité de deuxièmes pièces.

La pièce 180a est reliée électriquement en série à la pièce 190a au moyen d'un connecteur électrique 220 en bande disposé sur les faces extérieures des pièces 180a et 190a, selon une direction contenue dans un plan orthogonal à la direction longitudinale. Elle est aussi reliée électriquement en série à la pièce 190b au moyen d'un connecteur électrique 225 en bande disposé sur les faces intérieures des pièces 180a et 190b, selon une direction contenue dans un plan orthogonal à la direction longitudinale.

Par ailleurs, dans l'exemple de la figure 7, les pièces des pluralités de premières pièces et de deuxièmes pièces comportent des revêtements isolants en alumine, non représentés par souci de clarté, disposés sur les faces latérales d'extrémités respectives des blocs desdites pièces. En outre, les faces latérales d'extrémités 200a-b de la pièce 180a sont en contact avec les faces latérales d'extrémités respectives 205a-b et 210a-b des pièces 190a-b en regard de la pluralité de deuxièmes pièces. Autrement dit, les revêtements en alumine des pièces 180a, 190a et 190b sont pris en sandwich entre les blocs des pièces 180a et 190a d'une part et 180a et 190b d'autre part respectivement. De cette façon, les revêtements en alumine isolent électriquement la pièce 180a de la pièce 190a d'une part et la pièce 190b d'autre part.

Le courant généré par conversion thermoélectrique au sein des multiples blocs en siliciure circule ainsi selon un trajet sensiblement hélicoïdal autour de l'axe longitudinal au sein des pièces du générateur, en transitant entre deux pièces consécutives des pluralités de premières pièces et de deuxièmes pièces, au moyen d'un connecteur électrique tel que décrit précédemment.

En ce qui concerne l'échangeur de chaleur intérieur, de préférence, il est formé d'aluminium et présente une épaisseur de paroi comprise entre 0,3 mm et 0,8mm.

Pour sa part, l'échangeur de chaleur extérieur 170 est formé d'acier inoxydable. Il comporte des ailettes 230 faisant saillie radialement vers l'extérieur.

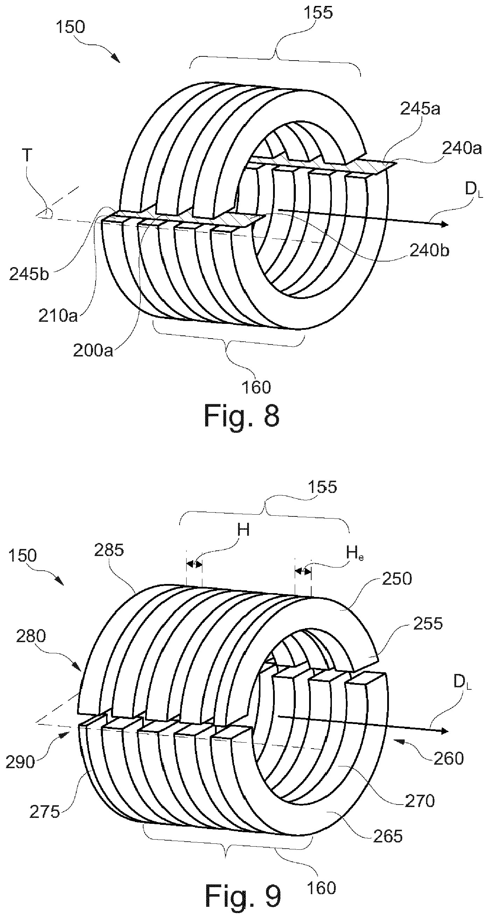

La figure 8 illustre une variante de réalisation de générateur thermoélectrique. Le générateur thermoélectrique 150 de la figure 8 comporte des pluralités de première pièces et de deuxièmes pièces telles qu'illustrées sur la figure 7, à ceci près que chacune des pièces desdites pluralités consiste en un bloc dont les faces latérales d'extrémité sont exemptes de tout revêtement isolant.

Pour assurer une isolation électrique entre des pièces adjacentes des pluralités de premières pièces et de deuxièmes pièces, le générateur électrique comporte deux plaques d'isolation 240a-b en matériau électriquement isolant isolant tel que l'alumine.

Les plaques d'isolation s'étendent selon une direction parallèle à la direction longitudinale du générateur thermoélectrique. De préférence, un plan médian 245a-b de chaque plaque d'isolation est contenu dans le plan T séparant les pluralités de premières pièces et de deuxièmes pièces.

Chacune des deux plaques d'isolation est prise en sandwich entre la pluralité 155 de premières pièces et la pluralité 160 de deuxièmes pièces, la plaque d'isolation étant en contact avec les faces latérales d'extrémité 200a-b de chaque pièce de la pluralité de premières pièces et avec les faces latérales d'extrémité 210a-b de chaque pièce de la pluralité de deuxièmes pièces.

Ainsi, les deux plaques d'isolation isolent électriquement et thermiquement chaque pièce de la pluralité de premières pièces, des pièces de la pluralité de deuxièmes pièces desquelles elle est adjacente et qui lui sont disposées en regard.

Enfin, la figure 9 illustre une extrémité d'un générateur thermoélectrique selon un mode de réalisation.

Le générateur thermoélectrique 150 comporte une pluralité de premières pièces et une pluralité de deuxièmes pièces telles que décrites précédemment, décalées l'une par rapport à l'autre le long de la direction longitudinale $D_L$ du générateur thermoélectrique.

La pluralité de premières pièces comporte une série de pièces de même hauteur régulièrement disposées le long de la direction longitudinale, ainsi qu'une pièce d'extrémité 250 disposée à une extrémité longitudinale 255 du générateur thermoélectrique.

La pièce d'extrémité 250 présente une hauteur He inférieure à la hauteur H de chacune des autres pièces de la pluralité de premières pièces à laquelle elle appartient, comme illustrée sur la figure 9.

La pièce d'extrémité 250 est disposée de sorte que la face transverse d'extrémité 260 du générateur thermoélectrique est située dans le même plan que la face transverse d'extrémité 265 de la pièce d'extrémité 270 de la pluralité de deuxièmes pièces. Ainsi, le générateur thermoélectrique présente une face d'extrémité 260 plane.

Bien évidemment, la pluralité de deuxièmes pièces peut comporter une autre pièce d'extrémité 275, de hauteur inférieure aux autres pièces de la pluralité de deuxièmes pièces, et disposée à l'extrémité opposée 280 du générateur thermoélectrique selon la direction longitudinale, de sorte à former avec une autre pièce d'extrémité 285 de la pluralité de pièces première, une autre face d'extrémité 290 plane du générateur thermoélectrique.

Bien entendu, l'invention n'est pas limitée aux modes de réalisation de la pièce et du générateur décrits dans la présente demande. D'autres variantes accessibles à l'homme du métier peuvent être envisagées.

Enfin, les expressions « comprenant un », « contenant un », « incluant un » sont équivalentes respectivement aux expressions « comprenant au moins un », « contenant au moins un » et « incluant au moins un ».

**Revendications**

1. Pièce (80) présentant une forme de secteur annulaire et comportant, pour au moins 95,0% de la masse de la pièce, un bloc (110) fritté présentant une forme de secteur annulaire et contenant un siliciure thermoélectrique dopé n ou dopé p, au moins une, de préférence les deux faces latérales d'extrémités (120a-b) du bloc étant chacune recouverte d'un revêtement isolant (115a-b) en un matériau électriquement et de préférence thermiquement isolant, de préférence étant de l'alumine.

2. Pièce selon la revendication 1, dans laquelle le siliciure thermoélectrique est choisi parmi MgSi, MgSiSn, MnSi, SiGe, $Mg_2Si$, $Mg_2SiSn$ et leurs mélanges.

3. Pièce selon l'une quelconque des revendications 1 et 2, dans laquelle l'étendue angulaire ($\Omega_2$) du bloc est supérieure à 45°, de préférence supérieure à 90°, voire de préférence supérieure à 175° et/ou inférieure à 180 °, notamment comprise entre 178,5° et 179,5°, notamment égale à 179°.

4. Pièce selon l'une quelconque des revendications précédentes, présentant une forme de portion d'anneau cylindrique de révolution et/ou dans laquelle le bloc est en forme de portion d'anneau cylindrique de révolution.

5. Pièce selon la revendication précédente, dans laquelle le bloc présente

   - un rayon intérieur (Ri) supérieur ou égal à 2 mm, de préférence supérieur ou égal à 4 mm, voire de préférence supérieur ou égal à 5 mm et/ou inférieur ou égal à 10 mm, de préférence inférieur ou égal à 8 mm, de préférence inférieur ou égal à 7 mm, notamment égal à 6 mm et/ou
   - un rayon extérieur ($R_e$) supérieur ou égal à 5 mm, de préférence supérieur ou égal à 7 mm, voire de préférence supérieur ou égal à 8 mm et/ou inférieur ou égal à 13 mm, de préférence inférieur ou égal à 11 mm, voire de préférence inférieur ou égal à 10 mm, notamment égal à 9 mm

et/ou

- une hauteur (H) supérieure ou égale à 1 mm, de préférence supérieure ou égale à 1,5 mm et/ou inférieure ou égale à 3 mm, de préférence inférieure ou égale à 2,5 mm.

6. Procédé de production d'une pièce selon l'une quelconque des revendications précédentes, le procédé comportant les étapes successives suivantes consistant à :

    a) disposer d'un mélange de matières premières pour former une charge de départ,
    b) mettre en forme une préforme à partir de la charge de départ,
    c) optionnellement, recouvrir partiellement, voire intégralement, au moins une face de la préforme d'un enduit, de sorte à obtenir une préforme recouverte,
    d) fritter la préforme, optionnellement recouverte, avec application d'une pression de sorte à obtenir une préforme frittée,
    e) optionnellement, revêtir au moins partiellement, voire intégralement, au moins une face de la préforme frittée d'un revêtement isolant comportant un matériau électriquement isolant et de préférence thermiquement isolant, de sorte à obtenir une préforme frittée revêtue,

    la préforme frittée, optionnellement revêtue à l'étape e), consistant en ladite pièce.

7. Générateur thermoélectrique (150) s'étendant selon une direction longitudinale ($D_L$) et comportant des première (180a-c) et deuxième (190a-c) pièces, chacune des première et deuxième pièces étant selon l'une quelconque des revendications 1 à 5, ou obtenue ou susceptible d'être obtenue par le procédé selon la revendication 6,
le siliciure thermoélectrique de la première pièce, respectivement de la deuxième pièce, étant dopé n, respectivement dopé p,
les première et deuxième pièces étant disposées autour de la direction longitudinale de sorte qu'au moins un plan de coupe (Q) du générateur thermoélectrique, normal à la direction longitudinale, coupe la première pièce et la deuxième pièce.

8. Générateur thermoélectrique selon la revendication 7, dans lequel les étendues angulaires des blocs respectifs des première et deuxième pièces sont égales, et de préférence comprises entre 178,5° et 179,5°.

9. Générateur thermoélectrique selon l'une quelconque des revendications 7 et 8, dans lequel, lorsqu'observée selon la direction longitudinale, la première pièce est symétrique de la deuxième pièce par rapport à un plan contenant ladite direction longitudinale.

10. Générateur thermoélectrique selon l'une quelconque des revendications 7 à 9, dans lequel les première et deuxième pièces sont décalées l'une par rapport à l'autre selon la direction longitudinale.

11. Générateur thermoélectrique selon l'une quelconque des revendications 7 à 10, comportant en outre au moins un organe isolant (240a-b) formé d'un matériau électriquement isolant, par exemple de l'alumine $Al_2O_3$, et de préférence thermiquement isolant, par exemple du quartz et/ou un verre, l'organe isolant étant disposé entre les première et deuxième pièces.

12. Générateur thermoélectrique selon l'une quelconque des revendications 7 à 11 comportant en outre un connecteur électrique (220;225) reliant électriquement en série les première et deuxième pièces, et étant de préférence constitué en tout ou partie par un métal choisi parmi le cuivre, le nickel, le molybdène et leurs mélanges.

13. Générateur thermoélectrique selon l'une quelconque des revendications 7 à 12, comportant une pluralité (155) de premières pièces (180a-c) et une pluralité (160) de deuxièmes pièces (190a-c), la pluralités de premières pièces, respectivement la pluralité de deuxièmes pièces étant au moins partiellement, voire intégralement, définie par répétition, de préférence périodique, selon la direction longitudinale, d'un motif élémentaire constitué par une première pièce (180c), respectivement par une deuxième pièce (190c).

14. Dispositif choisi parmi un pot d'échappement d'un véhicule automobile, notamment comportant un moteur à essence, un appareil de recirculation de gaz brûlé d'un moteur à explosion, notamment à essence ou diesel, d'un véhicule automobile, le dispositif comportant un générateur thermoélectrique selon l'une quelconque des revendications 7 à 13.

Fig. 1

Fig. 2

Fig. 3

Fig. 4

Fig. 5

Fig. 6

Fig. 7

Fig. 8

Fig. 9

Europäisches
Patentamt

European
Patent Office

Office européen
des brevets

**RAPPORT DE RECHERCHE EUROPEENNE**

Numéro de la demande

EP 17 20 7378

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | JP 2000 294840 A (YAMAHA CORP) 20 octobre 2000 (2000-10-20) * abrégé * * figures 1-4 * ----- | 1-5,7, 9-14 | INV. H01L35/32 H01L35/22 |
| Y | FR 3 021 161 A1 (COMMISSARIAT ENERGIE ATOMIQUE [FR]) 20 novembre 2015 (2015-11-20) * figures 1-5 * * page 4, lignes 22-24 * * page 4, ligne 28 - page 5, ligne 4 * * page 10, lignes 1-19 * ----- | 1,2,4,5, 7,9-14 | |
| Y | EP 1 662 588 A1 (NAGAMINE MFG CO LTD [JP]) 31 mai 2006 (2006-05-31) * abrégé * * figure 4 * ----- | 1-5,7, 9-14 | |
| A | FR 3 019 683 A1 (VALEO SYSTEMES THERMIQUES [FR]) 9 octobre 2015 (2015-10-09) * figures 1-3 * * page 10, lignes 15-25 * ----- | 1-14 | DOMAINES TECHNIQUES RECHERCHES (IPC) H01L |
| A | EP 2 439 799 A1 (SIEMENS AG [DE]) 11 avril 2012 (2012-04-11) * figures 1-3 * ----- | 1-14 | |

Le présent rapport a été établi pour toutes les revendications

| Lieu de la recherche | Date d'achèvement de la recherche | Examinateur |
|---|---|---|
| La Haye | 25 avril 2018 | Deconinck, Eric |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 17 20 7378

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-04-2018

| Document brevet cité au rapport de recherche | Date de publication | Membre(s) de la famille de brevet(s) | Date de publication |
|---|---|---|---|
| JP 2000294840 A | 20-10-2000 | AUCUN | |
| FR 3021161 A1 | 20-11-2015 | AUCUN | |
| EP 1662588 A1 | 31-05-2006 | AU 2003254915 A1<br>EP 1662588 A1<br>JP WO2005015649 A1<br>US 2006219282 A1<br>WO 2005015649 A1 | 25-02-2005<br>31-05-2006<br>05-10-2006<br>05-10-2006<br>17-02-2005 |
| FR 3019683 A1 | 09-10-2015 | FR 3019683 A1<br>WO 2015149953 A2 | 09-10-2015<br>08-10-2015 |
| EP 2439799 A1 | 11-04-2012 | EP 2439799 A1<br>US 2013255742 A1<br>WO 2012045542 A2 | 11-04-2012<br>03-10-2013<br>12-04-2012 |

EPO FORM P0460

Pour tout renseignement concernant cette annexe : voir Journal Officiel de l'Office européen des brevets, No.12/82